Europäisches Patentamt

European Patent Office

Office européen des brevets

(19)

(11) **EP 1 056 989 B1**

(12) **EUROPÄISCHE PATENTSCHRIFT**

(45) Veröffentlichungstag und Bekanntmachung des Hinweises auf die Patenterteilung:
**18.12.2002 Patentblatt 2002/51**

(21) Anmeldenummer: **99908836.2**

(22) Anmeldetag: **02.02.1999**

(51) Int Cl.$^7$: **G01D 5/245**, H03M 1/30

(86) Internationale Anmeldenummer:
**PCT/EP99/00673**

(87) Internationale Veröffentlichungsnummer:
**WO 99/042790 (26.08.1999 Gazette 1999/34)**

(54) **VERFAHREN ZUM BETRIEB EINES POSITIONSMESSSYSTEMS UND GEEIGNETES POSITIONSMESSSYSTEM HIERZU**

METHOD FOR OPERATING A POSITION MEASURING SYSTEM AND CORRESPONDING POSITION MEASURING SYSTEM

PROCEDE PERMETTANT DE FAIRE FONCTIONNER UN SYSTEME DE MESURE DE POSITION ET SYSTEME DE MESURE DE POSITION APPROPRIE

(84) Benannte Vertragsstaaten:
**DE FR GB IT**

(30) Priorität: **21.02.1998 DE 19807377**
**09.12.1998 DE 19856708**

(43) Veröffentlichungstag der Anmeldung:
**06.12.2000 Patentblatt 2000/49**

(73) Patentinhaber: **Dr. Johannes Heidenhain GmbH**
**83292 Traunreut (DE)**

(72) Erfinder: **HAGL, Rainer**
**D-83352 Altenmarkt (DE)**

(56) Entgegenhaltungen:
**WO-A-98/01724     DE-C- 19 513 692**
**US-A- 5 572 018**

EP 1 056 989 B1

**Beschreibung**

Die vorliegende Erfindung betrifft ein Verfahren zum Betrieb eines Positionsmeßsystems sowie ein geeignetes Positionsmeßsystem hierzu.

Es sind Positionsmeßsysteme zur Bestimmung der Relativposition zweier zueinander beweglicher Teile bekannt, die neben einer abgetasteten Inkrementalteilung ein oder mehrere Referenzmarkierungen zum Herstellen eines positionsmäßigen Absolutbezuges der beiden Teile aufweisen. Bis zum ersten oder zweiten Überfahren einer Referenzmarkierung werden dabei über die Abtasteinheit des Positionsmeßsystems inkrementale Abtastsignale erzeugt und einer Zählereinheit zugeführt. Von der Zählereinheit werden inkrementale Positionsdaten an eine nachgeordnete Auswerteeinheit in serieller Form übertragen. Dies bedeutet, daß zu definierten Abfragezeitpunkten auf Seiten des Positionsmeßsystems der aktuelle Zählerwert der Zählereinheit bestimmt und die inkrementalen Positionsdaten als Codewort an die Auswerteeinheit übertragen werden. Sobald das erste oder zweite Mal auf dem Maßstab des Positionsmeßsystems angeordnete Referenzmarkierungen von der Abtasteinheit überfahren werden, ist die exakte Absolutposition der beiden zueinander beweglichen Teile bekannt. Nachfolgend ist die Übertragung von Absolutpositionsdaten bzw. -signalen zu den vorgegebenen Abfragezeitpunkten in Form von Codewörtern an die Auswerteeinheit möglich. Hierbei kann der exakte Absolutbezug beispielsweise durch eine einzige Referenzmarkierung mit bekannter Lage ebenso hergestellt werden wie mittels mehrerer, sogenannter abstandscodierter Referenzmarkierungen.

Werden nunmehr die übertragenen, seriellen Positionsdaten von der Auswerteeinheit auch zur Geschwindigkeitsregelung benötigt, so resultieren Probleme bezüglich der exakten Geschwindigkeitsbestimmung beim Übergang von der Inkremental- zur Absolutpositions-Messung. Insbesondere ist bei der erstmaligen Übertragung von Absolutpositionsdaten in Form eines Codewortes, das die exakte Absolutposition angibt, keine korrekte Bestimmung der Relativgeschwindigkeit der beiden zueinander beweglichen Teile im vorangegangenen Abfragezeitpunkts-Intervall möglich.

Aufgabe der vorliegenden Erfindung ist es daher, ein Verfahren zum Betrieb eines Positionsmeßsystemes sowie ein geeignetes Positionsmeßsystem anzugeben, womit Positionsdaten in serieller Form an eine nachgeordnete Auswerteeinheit übertragen werden können. Dabei soll stets sichergestellt sein, daß eine korrekte Bestimmung der Relativgeschwindigkeit der beiden zueinander beweglichen Teile möglich ist.

Diese Aufgabe wird gelöst durch ein Verfahren mit den Merkmalen des Anspruches 1 und durch ein Positionsmeßsystem mit den Merkmalen des Anspruches 10.

Vorteilhafte Ausführungsformen der erfindungsgemäßen Verfahren bzw. der erfindungsgemäßen Positionsmeßsysteme ergeben sich aus den Maßnahmen in den jeweils abhängigen Ansprüchen.

Aufgrund der nunmehr erfindungsgemäß vorgesehenen Bildung eines Positionsdifferenzwertes nach dem Herstellen des Absolutbezuges ist sichergestellt, daß auch zu diesem Zeitpunkt eine eindeutige Bestimmung der Relativgeschwindigkeit der zwei zueinander beweglichen Teile möglich ist. Eine präzise Geschwindigkeitsregelung über die Auswerteeinheit ist somit gewährleistet.

In Bezug auf die Bildung des Positionsdifferenzwertes gibt es verschiedene Möglichkeiten; so kann gemäß Anspruch 2 vorgesehen werden, den Positionsdifferenzwert bereits auf Seiten des Positionsmeßsystems zu bilden und den ermittelten Wert zusammen mit den erstmalig übertragenen Absolutpositionsdaten zu übertragen.

Alternativ ist es gemäß Anspruch 8 aber auch grundsätzlich möglich, nach der Herstellung des Absolutbezuges sowohl die inkrementalen Positionsdaten als auch die Absolutpositionsdaten an die Auswerteeinheit zu übertragen und die Bildung des Positionsdifferenzwertes erst auf Seiten der Auswerteeinheit vorzunehmen.

Die erfindungsgemäßen Maßnahmen lassen sich selbstverständlich in Verbindung mit den verschiedensten Positionsmeßsystemen einsetzen. Dabei können zum einen unterschiedlichste physikalische Abtastprinzipien eingesetzt werden, z.B. optische, magnetische, induktive oder aber kapazitive - prinzipien. Ebenso können sowohl rotatorische Positionsmeßsysteme ebenso erfindungsgemäß ausgestaltet werden wie lineare Positionsmeßsysteme.

Weitere Vorteile sowie Einzelheiten der vorliegenden Erfindung ergeben sich aus der nachfolgenden Beschreibung von Ausführungsbeispielen anhand der beiliegenden Zeichnungen.

Dabei zeigt

Figur 1    ein schematisiertes Blockschaltbild eines Ausführungsbeispieles des erfindungsgemäßen Positionsmeßsystems in Verbindung mit einer Auswerteeinheit;

Figur 2    ein Positions-Zeit-Diagramm, ein abgetasteter Maßstab sowie ein Diagramm bzgl. der Übertragung eines Identifizierungssignales zur Erläuterung eines ersten Ausführungsbeispieles des erfindungsgemäßen Verfahrens bzw. der erfindungsgemäßen Vorrichtung;

Figur 3    ein Positions-Zeit-Diagramm, ein abgetasteter Maßstab sowie ein Diagramm bzgl. der Übertragung eines Identifizierungssignales zur Erläuterung eines zweiten Ausführungsbeispieles des erfindungsgemäßen Verfahrens bzw. der erfindungsgemäßen Vorrichtung;

Figur 4  ein Positions-Zeit-Diagramm, ein abgetasteter Maßstab sowie ein Diagramm bzgl. der Übertragung eines Identifizierungssignales zur Erläuterung eines dritten Ausführungsbeispieles des erfindungsgemäßen Verfahrens bzw. der erfindungsgemäßen Vorrichtung;

Figur 5  ein Positions-Zeit-Diagramm, ein abgetasteter Maßstab sowie ein Diagramm bzgl. der Übertragung eines Identifizierungssignales zur Erläuterung eines vierten Ausführungsbeispieles des erfindungsgemäßen Verfahrens bzw. der erfindungsgemäßen Vorrichtung.

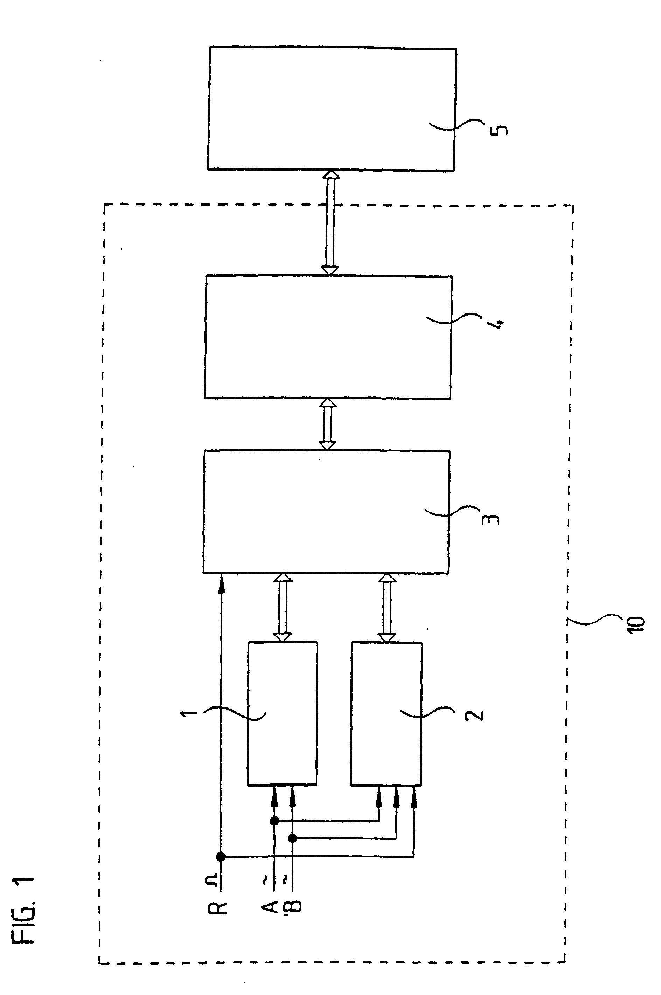

Figur 1 zeigt in schematischer Form ein Ausführungsbeispiel des erfindungsgemäßen Positionsmeßsystems 10 in Verbindung mit einer nachgeordneten Auswerteeinheit 5. Das Positionsmeßsystem 10 kann z.B. in einer numerisch gesteuerten Werkzeugmaschine eingesetzt werden; die Auswerteeinheit 5 entspricht in einer derartigen Anwendung dann der numerischen Werkzeugmaschinensteuerung.

Auf Seiten des Positionsmeßsystems 10 werden in bekannter Art und Weise um 90° phasenversetzte Inkrementalsignale A, B erzeugt. Dies kann beispielsweise durch die optische Abtastung einer Inkrementalteilung mit Hilfe einer Abtasteinheit erfolgen, wobei die Inkrementalteilung auf einem relativ zur Abasteinheit beweglichen Maßstab angeordnet ist. Desweiteren wird bei ein oder mehreren definierten Relativpositionen von Maßstab und Abtasteinheit ein Referenzsignal R erzeugt, um einen Absolutbezug der Relativ-Inkrementalmessung herzustellen. Zu diesem Zweck kann beispielsweise vorgesehen werden, seitlich benachbart zu einer Inkrementalteilungsspur auf dem Maßstab eine Referenzmarkierungsspur mit ein oder mehreren Referenzmarkierungen an definierten Absolutpositionen anzubringen.

Die Inkrementalsignale A, B werden im Positionsmeßsystem 10 einer ersten und zweiten Zählereinheit 1, 2 zugeführt, wo jeweils in bekannter Art und Weise ein Aufsummieren der positionsbezogenen Inkrementalsignale A, B erfolgt. Die jeweiligen Zählerstände der beiden Zählereinheiten 1, 2 werden an eine nachgeordnete Signalverarbeitungseinheit 3 im Positionsmeßsystem 10 übergeben. In der Signalverarbeitungseinheit 3 erfolgt die nachfolgend noch detailliert zu beschreibende Verarbeitung der verschiedenen Signale über das erfindungsgemäße Verfahren.

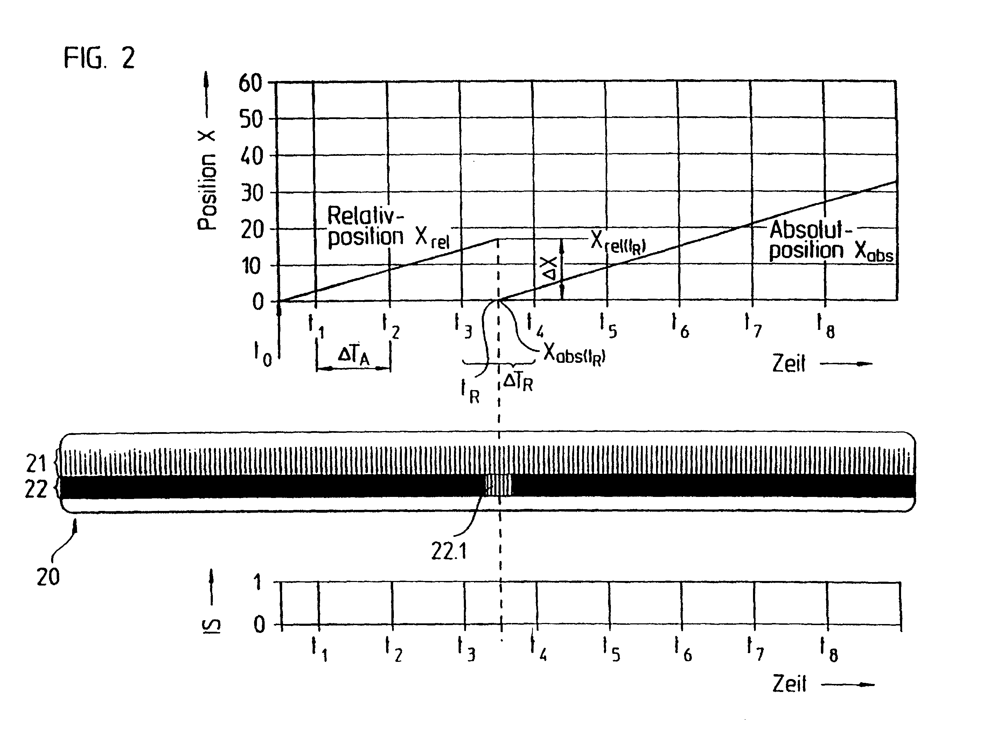

Das Referenzsignal R wird desweiteren der zweiten Zählereinheit 2 sowie der Signalverarbeitungseinheit 3 zugeführt. In Bezug auf die erfindungsgemäße Verarbeitung des Referenzsignales R als auch der beiden Inkrementalsignale A, B sei auf die nachfolgende Beschreibung von Ausführungsbeispielen des erfindungsgemäßen Verfahrens anhand der Figuren 2 - 5 verwiesen.

Über eine, der Signalverarbeitungseinheit 3 nachgeordneten Signalaufbereitungseinheit 4 werden die letztlich an die Auswerteeinheit 5 zu übertragenden, positionsbezogenen Daten derart aufbereitet, daß eine Übertragung verschiedener Daten in serieller Form, beispielsweise als geeignete Codewörter, möglich ist.

An dieser Stelle sei desweiteren darauf hingewiesen, daß die in Figur 1 gezeigte Darstellung lediglich schematisch zu verstehen ist. Dies bedeutet etwa, daß selbstverständlich sowohl lineare als auch rotatorische Positionsmeßsysteme erfindungsgemäß ausgestaltet werden können. Daneben können die erfindungsgemäßen Maßnahmen selbstverständlich auch in Verbindung mit anderen physikalischen Abtastprinzipien eingesetzt werden, beispielsweise in magnetischen, kapazitiven oder induktiven Positionsmeßsystemen. Ebenso existieren selbstverständlich verschiedenste weitere Möglichkeiten bezüglich der Erzeugung der Referenzsignale und der Anordnung der signalverarbeitenden Komponenten auf Seiten des Positionsmeßsystems etc. im Rahmen der erfindungsgemäßen Überlegungen.

Anhand der Figur 2 sei nachfolgend anhand eines ersten Ausführungsbeispiels das erfindungsgemäße Verfahren inclusive der zugehörigen Vorrichtung erläutert. Dargestellt ist hierbei der abgetastete Maßstab 20 in Verbindung mit einem Positions-Zeit-Diagramm sowie einem Diagramm bezüglich eines übertragenen Identifizierungssignales IS.

Auf Seiten des abgetasteten Maßstabes 20 ist in diesem Ausführungsbeispiel lediglich eine einzige Referenzmarkierung 22.1 in einer Referenzmarkierungsspur 22 seitlich benachbart zu einer Inkrementalteilungsspur 21 angeordnet. Über die Referenzmarkierung 22.1 ist eine definierte Absolutposition zwischen dem Maßstab 20 und der - nicht gezeigten - Abtasteinheit bestimmbar. Dargestellt ist im Positions-Zeit-Diagramm der Figur 2, wie zu Meßbeginn nach dem Einschalten der Versorgungsspannung zum Zeitpunkt $t_0$ zunächst die Relativposition $x_{rel}$ der beiden zueinander beweglichen Teile über eine Inkrementalmessung bestimmt wird. Die dabei erzeugten Inkrementalsignale A, B ermöglichen noch keine definierte Kenntniss der exakten Absolutposition von Maßstab 20 und Abtasteinheit. Die jeweiligen Inkrementalsignale A, B werden in dieser Meßphase der ersten Zählereinheit zugeführt, deren jeweiliger Zählerstand den inkrementalen Positionsdaten $x_{rel}$ entspricht. Der Zählerstand mit den relativen Positionsdaten $x_{rel}$ bzw. den inkrementalen Positionsdaten wird nach einer geeigneten Verarbeitung und Aufbereitung in serieller Form als Codewort $x_{rel}(t_n)$ bzw. Datenwort zu vorgegebenen Abfragezeitpunkten $t_n$ (n = 1, 2, 3....) an die nachgeordnete Auswerteeinheit übertragen. Wenngleich auswerteseitig in dieser Meßphase noch keine exakte Positionsregelung aufgrund des noch nicht bekannten Absolutbezuges möglich ist, so kann mit Hilfe der übertragenen inkrementalen Positionsdaten bzw. der Zählerwerte bzgl. der Relativpositionen $x_{rel}(t_n)$ zumindest bereits die Geschwindigkeits- oder Drehzahlregelung eines Antriebes vorgenommen werden, der die Relativbewegung bewirkt. Hierzu kann auf Seiten der Auswerteinheit die Relativgeschwindigkeit v der zueinander beweglichen Teile im jeweils vorhergehenden Abfrageintervall $\Delta T_a$ beispielsweise über folgende Beziehung bestimmt werden:

$$v = (x_{rel}(t_n) - x_{rel}(t_{n-1}))/ \Delta T_a \qquad \text{(Gl. 1)}$$

mit

v: Relativgeschwindigkeit der beiden Teile
$x_{rel}(t_n)$: übertragene inkrementale Positionsdaten zu den Abfragezeitpunkten $t_n$ bzw. $t_{n-1}$
$\Delta T_a$: Dauer des Abfrageintervalles

Zwischen den beiden Abfragezeitpunkten $t_3$ und $t_4$ wird zum Zeitpunkt $t_R$ im Beispiel nunmehr die Referenzmarkierung 22.1 auf dem Maßstab 20 überfahren und ein entsprechendes Referenzsignal R in bekannter Art und Weise erzeugt bzw. detektiert. Ab diesem Zeitpunkt $t_R$ ist die Absolutposition $x_{abs}$ der beiden zueinander beweglichen Teile exakt bekannt. Auf die nunmehr bekannte Absolutposition $x_{abs}$ kann in der nachfolgenden Meßphase die weitere Inkrementalmessung bezogen werden.

Sobald zum Zeitpunkt $t_R$ das Referenzsignal R detektiert wird, wird die zweite Zählereinheit im gezeigten Ausführungsbeispiel auf den Positionswert $x_{abs}(t_R)$ = 0 gesetzt und anschließend ab dem gesetzten Zählerwert $x_{abs}(t_R)$ = 0 inkremental weiter gemessen. Das Referenzsignal R wird hierbei sowohl der zweiten Zählereinheit als auch der Signalverarbeitungseinheit zugeführt.

Selbstverständlich kann der Zählerwert $x_{abs}$ der zweiten Zählereinheit zum Zeitpunkt $t_R$ auch auf einen anderen definierten, absoluten Positionswert $x_{abs}(t_R)$ gesetzt werden, der ungleich Null ist.
Zum Abfragezeitunkt $t_4$ können demzufolge zum ersten Mal korrekte Absolutpositionsdaten in Form des Zählerwertes $x_{abs}(t_4)$ an die Auswerteinheit übertragen werden. Diese Absolutpositionsdaten entsprechen wiederum einem bekannten Zählerstand der zweiten Zählereinheit, der in geeigneter Form als Datenwort im Dualcode bzw. als Codewort aufbereitet an die Auswerteinheit übertragen wird.

In der ersten Meßphase bis zum Erreichen der Referenzmarkierung 22.1 wird zusammen mit den seriell übertragenen inkrementalen Positionsdaten $x_{rel}(t_n)$ ein Identifizierungssignal IS an die Auswerteinheit übertragen, anhand dessen die Auswerteinheit erkennt, daß noch kein exakter Absolutbezug bei der Messung hergestellt wurde und derzeit noch die Relativpositionsdaten ohne Absolutbezug übertragen werden. Das Identifizierungssignal IS besteht im gezeigten Ausführungsbeispiel dabei aus einem Bit, das in Verbindung mit dem Codewort seriell übertragen wird und in dieser Meßphase auf "0" gesetzt ist. Nach dem Herstellen des Absolutbezuges durch das Überfahren der Referenzmarkierung 22.1 wird nachfolgend dieses Bit des Identifizierungssignales IS auf "1" gesetzt und ebenfalls seriell in Verbindung mit dem Codewort bezüglich der dann bekannten Absolutposition $x_{abs}$ zu den Abfragezeitpunkten $t_n$ (n>3) an die Auswerteinheit übertragen. Auf diese Art und Weise ist gewährleistet, daß auf Seiten der Auswerteinheit stets die aktuelle Art der Positionsmessung bekannt ist.

Um nunmehr erfindungsgemäß sicherzustellen, daß zu jedem Abfragezeitpunkt $t_n$ eine korrekte Geschwindigkeits- oder Drehzahlregelung auf Basis der an die Auswerteinheit übertragenen Daten möglich ist, wird in diesem Ausführungsbeispiel beim Überfahren der Referenzmarkierung 22.1 zum Zeitpunkt $t_R$ über die Signalverarbeitungseinheit der Positionsdifferenzwert $\Delta x$ zwischen dem letzten relativen Positionswert $x_{rel}(t_R)$ und dem ersten bekannten absoluten Positionswert $x_{abs}(t_R)$ auf der Seite des Positionsmeßsystems bestimmt. Der ermittelte Positionsdifferenzwert $\Delta x = x_{rel}(t_R) - x_{abs}(t_R)$ wird zum nachfolgenden Abfragezeitpunkt $t_4$ zusammen mit dem Codewort bezüglich der Absolutposition und dem Identifizierungssignal IS an die Auswerteinheit übertragen. Auf Seiten der Auswerteinheit kann mit Hilfe des Positionsdifferenzwertes $\Delta x$ damit auch im vorangegangenen Abfrageintervall $\Delta T_R$ zwischen den Abfragezeitpunkten $t_3$ und $t_4$ korrekt die Relativgeschwindigkeit der beiden zueinander beweglichen Teile bestimmt werden. Dies erfolgt beispielsweise über die folgende Beziehung:

$$v = (x_{abs}(t_4) - x_{rel}(t_3) - \Delta x)/ \Delta T_a \qquad \text{(Gl. 2)}$$

wobei wie oben gilt:

v: Relativgeschwindigkeit der beiden Teile
$x_{abs.rel}$: übertragene Positionswerte zu den Abfragezeitpunkten $t_3$ und $t_4$
$\Delta T_a$: Dauer des Abfrageintervalles

Auch im Abfrageintervall $\Delta T_R$ vor der erstmaligen Übertragung des Absolutpositionssignales kann damit die korrekte Geschwindigkeit v der beiden zueinander beweglichen Teile auf Seiten der Auswerteinheit bestimmt werden. Eine hochpräzise Geschwindigkeitsregelung zu jedem Zeitpunkt ist damit sichergestellt, insbesondere bei der Herstellung des exakten Absolutbezuges.

Die vorab erläuterte Verarbeitung der verschiedenen Zählerstände, Herstellen des Absolutbezuges, Berechnen des Positionsdifferenzwertes, Umschalten des Identifizierungssignales etc. erfolgt hierbei mit Hilfe der in Figur 1 angedeuteten Signalverarbeitungseinheit auf Seiten des Positionsmeßsystemes. Diese kann in geeigneter Form hard- oder softwaremäßig ausgebildet werden.

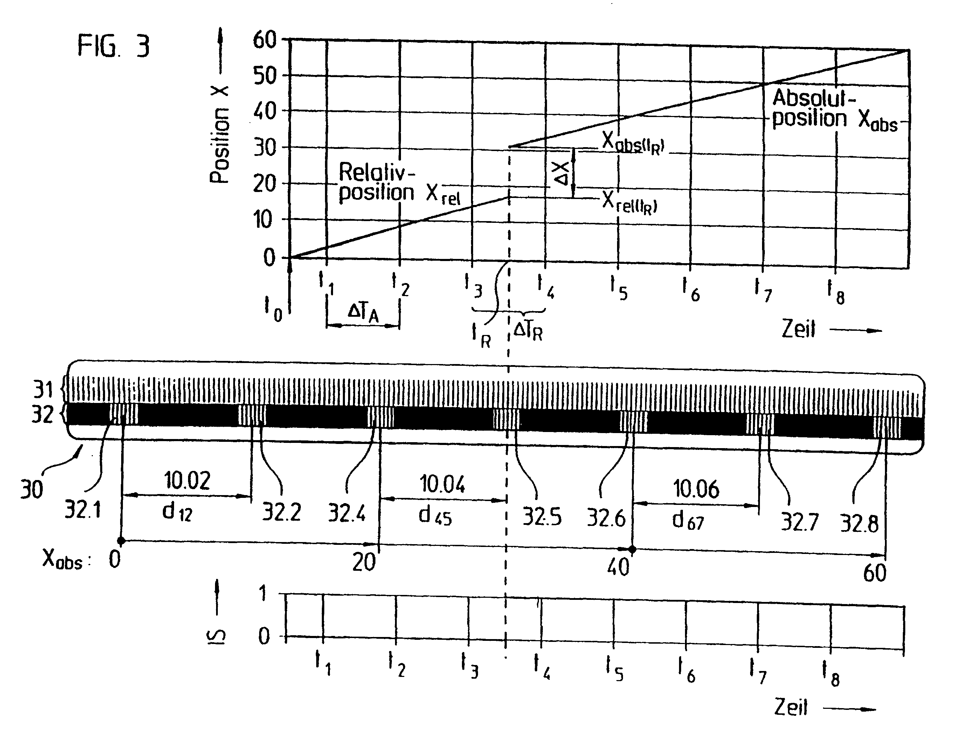

Eine zweite mögliche Ausführungsform des erfindungsgemäßen Verfahrens bzw. Positionsmeßystems sei nachfolgend anhand der Figur 3 erläutert. Gezeigt ist wiederum ein Positions-Zeit-Diagramm, ein abgetasteter Maßstab 30 sowie ein Diagramm bezüglich des übertragenen Identifizierungssignales IS. Ferner ist unterhalb des Maßstabes 30 eine Achse mit den Absolutpositonen $x_{abs}$ in willkürlichen Einheiten dargestellt. Im Unterschied zur vorab erläuterten Variante ist nunmehr vorgesehen, auf dem Maßstab 30 zur Herstellung des Absolutbezuges sogenannte abstandscodierte Referenzmarkierungen 32.1 - 32.8 in einer Referenzmarkierungsspur 32 seitlich benachbart zu einer Inkrementalteilungsspur 31 anzuordnen. Um den gewünschten Absolutbezug bei der Positionsmessung herzustellen, ist dabei das Überfahren von mindestens zwei Referenzmarkierungen 32.1 - 32.8 erforderlich, deren Abstand $d_{nm}$ zueinander über eine Inkrementalmessung bestimmt wird.

Im dargestellten Beispiel wird nach Einschalten der Stromversorgung zum Zeitpunkt $t_0$ zunächst wie in der vorhergehenden Variante die Relativposition $x_{rel}$ der beiden zueinander beweglichen Teile über eine Relativmessung durch die Abtastung der Inkrementalteilungsspur 31 bestimmt. Die Inkrementalsignale A, B der Abtastung werden hierbei ebenfalls einer ersten Zählereinheit zugeführt, die die Zählerwerte in Form der Relativpositionen von $x_{rel} = 0$ beginnend in dieser Meßphase aufsummiert. Die Zählerwerte $x_{rel}(t_n)$ der ersten Zählereinheit bzgl. der Relativposition von Maßstab 30 und Abtasteinheit werden wiederum als inkrementale Positionsdaten in serieller Form als Dualwort codiert zu den Abfragezeitpunkten $t_n$ (n = 1, 2, 3....) an die nachgeordnete Auswerteeinheit übertragen.

Zwischen den Abfragezeitpunkten $t_1$ und $t_2$ wird hierbei das erste Mal eine Referenzmarkierung 32.4 überfahren, zwischen den Abfragezeitpunkten $t_3$ und $t_4$ eine zweite Referenzmarkierung 32.5; der zwischen diesen Referenzmarkierungen liegende Abstand $d_{45} = 10{,}04$ wird über die Inkrementalmessung bestimmt. Aufgrund des bekannten Abstandes $d_{45}$ zwischen den beiden überfahrenen Referenzmarkierungen 32.4 und 32.5 ist demzufolge zum Zeitpunkt $t_R$ die exakte Absolutposition $x_{abs}(t_R) = 30$ des Maßstabes 30 in Bezug auf die - nicht dargestellte - Abtasteinheit bekannt. Ab dem Abfragezeitpunkt $t_4$ kann somit die exakte Absolutposition $x_{abs}(t_4)$ zwischen den beiden beweglichen Teilen zu den Abfragezeitpunkten $t_n$ (n ≥ 4) an die Auswerteeinheit übertragen werden. Beim Überfahren der zweiten Referenzmarkierung 32.5 wird eine zweite Zählereinheit hierzu auf den korrekten Absolutpositionswert $x_{abs} = 30$ gesetzt und nachfolgend der Zählerstand der zweiten Zählereinheit über die Inkrementalmessung aktualisiert, indem eine entsprechende Aufsummierung erfolgt.

Um nunmehr wiederum zu jedem Zeitpunkt eine korrekte Geschwindigkeitsbestimmung auf Seiten der Auswerteeinheit und demzufolge eine entsprechende -regelung derselben zu ermöglichen, wird beim Überfahren der Referenzmarkierung 32.5 zum Zeitpunkt $t_R$ der Positionsdifferenzwert $\Delta x$ zwischen dem letzten relativen Positionswert $x_{rel}(t_R)$ der ersten Zählereinheit und dem ersten bekannten absoluten Positionswert $x_{abs}(t_R)$ der zweiten Zählereinheit auf der Seite des Positionsmeßsystems bestimmt. Der ermittelte Positionsdifferenzwert $\Delta x = x_{rel}(t_R) - x_{abs}(t_R)$ wird auch im zweiten Ausführungsbeispiel zum nachfolgenden Abfragezeitpunkt $t_4$ zusammen mit dem Codewort bezüglich der Absolutposition $x_{abs}(t4)$ und einem Identifizierungssignal IS an die Auswerteeinheit übertragen. Bezüglich des Identifizierungssignales IS sei im übrigen auf das oben erläuterte erste Ausführungsbeispiel verwiesen.

Auf Seiten der Auswerteeinheit kann mit Hilfe des Positionsdifferenzwertes $\Delta x$ damit auch im vorangegangenen Abfrageintervall $\Delta T_R$ zwischen den Abfragezeitpunkten $t_3$ und $t_4$ z.B. über die bereits oben angegebene Gleichung (2) korrekt die Relativgeschwindigkeit der beiden zueinander beweglichen Teile bestimmt werden. Auch zum Zeitpunkt der Herstellung des Absolutbezuges ist somit eine exakte Geschwindigkeits- bzw. Drehzahlregelung möglich.

Die verschiedenen Komponenten der in Figur gezeigten Positionsmeßeinrichtung übernehmen auch im zweiten Ausführungsbeispiel die grundsätzlich ähnlichen Aufgaben wie im erläuterten ersten Ausführungsbeispiel.

In den beiden bislang erläuterten Ausführungsbeispielen war jeweils vorgesehen, den Positionsdifferenzwert $\Delta x$ auf Seiten des Positinsmeßsystems zu ermitteln und an die nachgeordnete Auswerteeinheit zu übertragen. Nachfolgend seien zwei weitere erfindungsgemäße Varianten erläutert, in denen die Bildung des Positionsdifferenzwertes $\Delta x$ auf Grundlage der übertragenen Daten erst auf Seiten der Auswerteeinheit erfolgt.

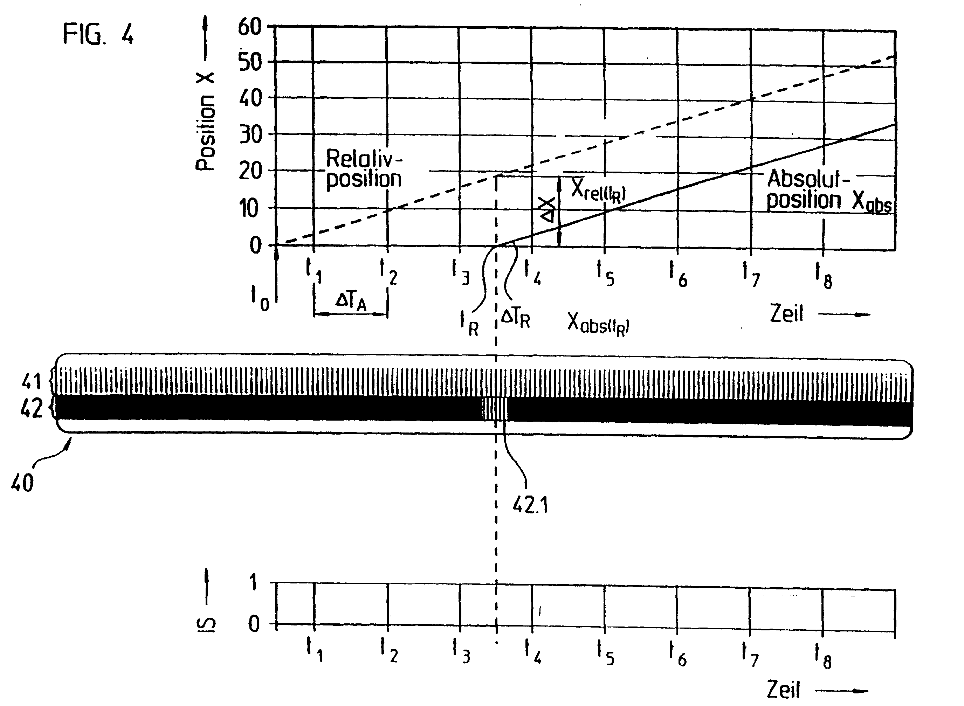

So zeigt Figur 4 wiederum ein Positions-Zeit-Diagramm, einen abgetasteten Maßstab 40 sowie ein Diagramm bezüglich des übertragenen Identifizierungssignales IS. Ferner ist unterhalb des Maßstabes 40 eine Achse mit den Absolutpositionen $x_{abs}$ in willkürlichen Einheiten dargestellt. Nachfolgend sei lediglich auf die entscheidenden Unterschiede dieser Variante gegenüber dem Beispiel in Figur 2 eingegangen; ansonsten sei in Bezug auf die Beschriftung und die Bezugszeichen auf Figur 2 verwiesen.

Im Unterschied zum Ausführungsbeispiel in Figur 2 ist nunmehr vorgesehen, auch dem Erreichen der Referenzmarkierung 42.1 weiterhin inkrementale Positionsdaten $x_{rel}(t_n)$ neben bzw. zusätzlich zu den Absolutpositionsdaten $x_{abs}(t_n)$ zu übermitteln. Dies erfolgt durch die serielle Übertragung der entsprechenden Zählerstände der beiden Zählereinheiten im Rahmen des vorgesehenen Übertragungsprotokolles. Die Bildung des Positionsdifferenzwertes $\Delta x$, die zur präzisen Geschwindigkeitsregelung erforderlich ist, erfolgt auf Grundlage der übertragenen Positionsdaten bzw. Zählerstände dann erst auf Seiten der Auswerteeinheit. Hierbei wird der Positionsdifferenzwert $\Delta x$ in der Auswerteeinheit ebenso gebildet wie in den vorhergehenden Beispielen.

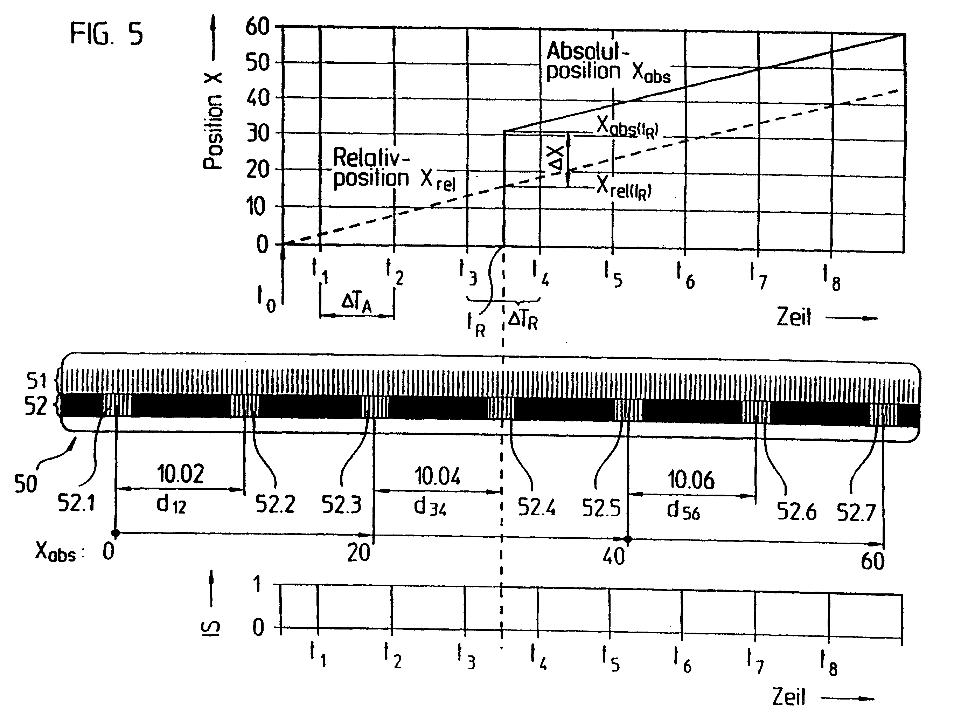

Ein ähnliches Vorgehen ist auch im vierten Ausführungsbeispiel vorgesehen, das anhand der Figur 5 kurz beschrieben sei. Diese Variante entspricht wiederum grundsätzlich dem in Figur 3 bereits ausführlich erläuterten Beispiel mit abstandscodierten Referenzmarkierungen. Es sei demzufolge nur auf die Unterschiede zur bereits beschriebenen Ausführungsform eingegangen.

Wie im Beispiel der Figur 4 ist vorgesehen, nach dem Herstellen des Absolutbezuges, d.h. dem Überfahren der zweiten Referenzmarkierung 52.4 zum Zeitpunkt $t_R$, neben den Absolutpositionsdaten $x_{abs}(t_n)$ auch weiterhin die inkrementalen Positionsdaten $x_{abs}(t_n)$ an die Auswerteeinheit zu übertragen. Dies erfolgt wiederum durch die entsprechende Übertragung der jeweiligen Zählerstände der beiden Zählereinheiten zu den Abfragezeitpunkten $t_n$ in serieller Form. Die Bildung des Positionsdifferenzwertes $\Delta x$ erfolgt wie vorab erläutert demzufolge erst wieder in der Auswerteeinheit auf Grundlage der übertragenen Daten bzgl. relativer und absoluter Position.

Neben den beschriebenen Ausführungsbeispielen existieren selbstverständlich noch diverse weitere Möglichkeiten, die erfindungsgemäßen Verfahren geeignet abzuwandeln.

**Patentansprüche**

1. Verfahren zum Betrieb eines Positionsmeßsystems, wobei

   - nach dem Meßbeginn Inkrementalsignale (A, B) bezüglich der Relativposition zweier zueinander beweglicher Teile über das Positionsmeßsystem erzeugt und an eine Auswerteeinheit (5) inkrementale Positionsdaten ($x_{rel}(t_n)$) in serieller Form zu vorgegebenen Abfragezeitpunkten ($t_n$) übertragen werden,
   - ab einer bekannten, definierten Absolutposition der beiden zueinander beweglichen Teile Absolutpositionsdaten ($x_{abs}(t_n)$) zu den vorgegebenen Abfragezeitpunkten ($t_n$) an die Auswerteeinheit (5) in serieller Form übertragen werden und
   - nach dem Erreichen der Absolutposition ein Positionsdifferenzwert ($\Delta x$) gebildet wird, der die im vorangegangenen Abfrage-Intervall bestimmte Differenz zwischen den zuletzt bestimmten inkrementalen Positionsdaten ($x_{rel}$)

und den erstmalig bestimmten Absolutpositionsdaten ($x_{abs}$) angibt.

2. Verfahren nach Anspruch 1, wobei der Positionsdifferenzwert ($\Delta x$) auf Seiten des Positionsmeßsystems gebildet wird und bei der erstmaligen Übertragung von Absolutpositionsdaten ($x_{abs}(t_n)$) der Positionsdifferenzwert ($\Delta x$) zusätzlich an die Auswerteeinrichtung übertragen wird.

3. Verfahren nach Anspruch 2, wobei die inkrementalen Positionsdaten ($x_{rel}(t_n)$) auf der Seite des Positionsmeßsystems über eine erste Zählereinheit (1) und die Absolutpositionsdaten ($x_{abs}(t_n)$) über eine zweite Zählereinheit (2) bestimmt werden und bei der erstmaligen Übertragung der Absolutpositionsdaten ($x_{abs}(t_n)$) zusätzlich die Differenz der beiden Zählerstände bei der definierten Absolutposition als Positionsdifferenzwert ($\Delta x$) an die Auswerteeinheit (5) übertragen wird.

4. Verfahren nach Anspruch 1, wobei bis zum erstmaligen Erreichen einer Referenzmarkierung (22.1) auf dem Maßstab (20) des Positionsmeßsysterns an einer definierten Absolutposition inkrementale Positionsdaten ($x_{rel}(t_n)$) an die Auswerteeinheit (5) übertragen werden.

5. Verfahren nach Anspruch 1, wobei inkrementale Positionsdaten ($x_{rel}(t_n)$) an die Auswerteeinheit (5) übertragen werden, bis zwei Referenzmarkierungen (32.4, 32.5) auf dem Maßstab (30) des Positionsmeßsystems überfahren wurden, aus deren Relativabstand ($d_{45}$) sich die definierte Absolutposition der zweiten überfahrenen Referenzmarkierung (32.5) auf dem Maßstab (30) bestimmen läßt.

6. Verfahren nach Anspruch 1, wobei sowohl bezüglich der inkrementalen Positionsdaten ($x_{rel}(t_n)$) wie auch bezüglich der Absolutpositiondaten ($x_{abs}(t_n)$) jeweils ein eindeutiges Identifizierungssignal (IS) bezüglich der gerade übertragenen Signalart an die Auswerteeinheit (5) übertragen wird.

7. Verfahren nach Anspruch 5, wobei das übertragene Identifizierungssignal (IS) zwei mögliche, logische Zustände einnehmen kann, die eindeutig mit der Übertragung der inkrementalen Positionsdaten ($x_{rel}(t_n)$) oder der Absolutpositionsdaten ($x_{abs}(t_n)$) verbunden sind.

8. Verfahren nach Anspruch 1, wobei nach dem Erreichen der Absolutposition sowohl inkrementale Positionsdaten ($x_{rel}(t_n)$) als auch Absolutpositionsdaten ($x_{abs}(t_n)$) vom Positionsmeßsystem an die Auswerteeinheit (5) übertragen werden und die Bildung des Positionsdifferenzwertes ($\Delta x$) aus den übertragenen Daten ($x_{rel}(t_n)$), ($x_{abs}(t_n)$)) auf Seiten der Aus-

werteeinheit (5) erfolgt.

9. Verfahren nach Anspruch 1, wobei mit Hilfe des Positionsdifferenzwertes die Relativgeschwindigkeit zwischen den zueinander beweglichen Teilen in einem Abfrageintervall bestimmt wird, das der erstmaligen Übertragung von Absolutpositionsdaten ($x_{abs}(t_n)$) vorhergeht.

10. Positionsmeßsystem zur Bestimmung der Relativposition zweier zueinander beweglicher Teile mit

   - Mitteln zum Erkennen einer bekannten, definierten Absolutposition ($x_{abs}(t_R)$) der beiden zueinander beweglichen Teile,
   - Mitteln zum seriellen Übertragen von inkrementalen Positionsdaten ($x_{rel}(t_n)$) und Absolutpositionsdaten ($x_{abs}(t_n)$) an eine Auswerteeinheit (5), wobei eine serielle Übertragung von Absolutpositionsdaten ($x_{abs}(t_n)$) nach dem Erkennen der bekannten Absolutposition erfolgt und
   - zwei Zählereinheiten (1, 2), von denen die erste Zählereinheit (1) ausgangsseitig die inkrementalen Positionsdaten ($x_{rel}(t_n)$) liefert, während die zweite Zählereinheit (2) ausgangsseitig die Absolutpositionsdaten ($x_{abs}(t_n)$) liefert.

11. Positionsmeßsystem nach Anspruch 10, wobei den beiden Zählereinheiten eine Signalverarbeitungseinheit (3) nachgeordnet ist, die gewährleistet, daß bei der erstmaligen Übertragung von Absolutpositionsdaten ($x_{abs}(t_n)$) ein Positionsdifferenzwert ($\Delta x$) an die Auswerteeinheit (5) übertragbar ist, der die Differenz zwischen den zuletzt bestimmten inkrementalen Positiondaten und den erstmalig bestimmten Absolutpositionsdaten angibt.

12. Positionsmeßsystem nach Anspruch 10, wobei mit den inkrementalen Positionsdaten ($x_{rel}(t_n)$) als auch mit den Absolutpositionsdaten ($x_{abs}(t_n)$) jeweils zugehöriges Identifizierungssignal (IS) an die Auswerteeinheit (5) übertragbar ist.

13. Positionsmeßsystem nach Anspruch 10, wobei zur Bestimmung einer Absolutposilion mindestens eine Referenzmarkierung (22.1) auf dem Maßstab (20) der Positionsmeßeinrichtung (10) an einer definierten Absolutposition angeordnet ist.

14. Positionsmeßsystem nach Anspruch 10, wobei zur Bestimmung einer Absolutposition mindestens zwei Referenzmarkierungen (32.4, 32.5) auf dem Maßstab (30) der Positionsmeßeinrichtung (10) mit einem eindeutig definierten Abstand ($d_{45}$) zueinander angeordnet sind.

**Claims**

1. Method for operating a position measuring system, wherein

   - after measurement starts, incremental signals (A, B) relating to the relative position of two parts which can be moved relative to one another, are generated using the position measuring system and incremental position data ($x_{rel}(t_n)$) are transmitted in serial form to an evaluation unit (5) at predetermined sampling times ($t_n$),
   - from a known, defined absolute position of the two parts which can be moved relative to one another, absolute position data ($x_{abs}(t_n)$) are transmitted in serial form to the evaluation unit (5) at the predetermined sampling times ($t_n$), and
   - after the absolute position has been reached, a differential position value (Dx) is formed, which indicates the difference, determined in the preceding sampling interval, between the most recently determined incremental position data ($x_{rel}$) and the absolute position data ($x_{abs}$) determined for the first time.

2. Method according to claim 1, wherein the differential position value (Dx) is determined by the position measuring system, and when absolute position data ($x_{abs}(t_n)$) are transmitted for the first time, the differential position value (Dx) is transmitted in addition to the evaluation unit.

3. Method according to claim 2, wherein the incremental position data ($x_{rel}(t_n)$) are determined on the part of the position measuring system via a first counter unit (1) and the absolute position data ($x_{abs}(t_n)$) via a second counter unit (2) and when the absolute position data ($x_{abs}(t_n)$) are transmitted for the first time, the difference between the two counts at the defined absolute position is transmitted in addition to the evaluation unit (5) as the differential position value (Dx).

4. Method according to claim 1, wherein, incremental position data ($x_{rel}(t_n)$) are transmitted to the evaluation unit (5) until a reference mark (22.1) on the scale (20) of the position measuring system at a defined absolute position is reached for the first time.

5. Method according to claim 1, wherein incremental position data ($x_{rel}(t_n)$) are transmitted to the evaluation unit (5) until two reference marks (32.4, 32.5) on the scale (30) of the position measuring system have been passed, from the relative spacing ($d_{45}$) of which the defined absolute position of the second reference mark (32.5) passed on the scale (30) can be determined.

6. Method according to claim 1, wherein, with respect to both the incremental position data ($x_{rel}(t_n)$) and the absolute position data ($x_{abs}(t_n)$), in each case a clear identification signal (IS) relating to the type of signal just transmitted is transmitted to the evaluation unit (5).

7. Method according to claim 5, wherein the transmitted identification signal (IS) can assume two possible logical states, which are clearly connected to the transmission of the incremental position data ($x_{rel}(t_n)$) or the absolute position data ($x_{abs}(t_n)$).

8. Method according to claim 1, wherein, after the absolute position has been reached, both incremental position data ($x_{rel}(t_n)$) and absolute position data ($x_{abs}(t_n)$) are transmitted from the position measuring system to the evaluation unit, and the calculation of the differential position value (Dx) from the transmitted data ($x_{rel}(t_n)$, ($x_{abs}(t_n)$)) is performed by the evaluation unit (5).

9. Method according to claim 1, wherein, with the aid of the differential position value, the relative speed between the parts which can be moved relative to one another is determined in a sampling interval which precedes the transmission of absolute position data ($x_{abs}(t_n)$) for the first time.

10. Position measuring system for determining the relative position of two parts which can be moved relative to one another, having

    - means for recognising a known defined absolute position ($x_{abs}(t_n)$) of the two parts which can be moved relative to one another,
    - means for the serial transmission of incremental position data ($x_{rel}(t_n)$) and absolute position data ($x_{abs}(t_n)$) to an evaluation unit (5), serial transmission of absolute position data ($x_{abs}(t_n)$) taking place after the known absolute position has been recognised, and
    - two counter units (1, 2), of which the first counter unit (1) delivers the incremental position data ($x_{rel}(t_n)$) at its output, whilst the second counter unit (2) delivers the absolute position data ($x_{abs}(t_n)$) at its output.

11. Position measuring system according to claim 10, wherein a signal processing unit (3) is located downstream of the two counter units, which guarantees that when absolute position data ($x_{abs}(t_n)$) are transmitted for the first time, a differential position value (Dx), which indicates the difference between the most recently determined incremental position data and the absolute position data determined for the first time, can be transmitted to the evaluation unit (5).

12. Position measuring system according to claim 10, wherein the respectively associated identification signal (IS) can be transmitted to the evaluation unit (5) both with the incremental position data ($x_{rel}(t_n)$) and with the absolute position data ($x_{abs}(t_n)$).

13. Position measuring system according to claim 10, wherein, to determine an absolute position, at least one reference mark (22.1) on the scale (20) of the position measuring device (10) is arranged at a defined absolute position.

14. Position measuring system according to claim 10, wherein, to determine an absolute position, at least two reference marks (32.4, 32.5) are arranged on the scale (30) of the position measuring device (10) at a clearly defined spacing ($d_{45}$) from each other.

**Revendications**

1. Procédé d'exploitation d'un système de mesure de position, selon lequel

    - après le début de la mesure, des signaux incrémentaux (A, B) concernant la position relative de deux éléments pouvant être déplacés l'un par rapport à l'autre sont produits par l'intermédiaire du système de mesure de position, et des données de position incrémentales ($x_{rel}(t_n)$) sont transmises en série à une unité d'exploitation (5), à des instants d'interrogation ($t_n$) prédéterminés,
    - à partir d'une position absolue définie connue des deux éléments mobiles l'un par rapport à l'autre, des données de position absolue ($x_{abs}(t_n)$) sont transmises en série à l'unité d'exploitation (5), aux instants d'interrogation ($t_n$) prédéterminés, et
    - après que la position absolue a été atteinte, une valeur différentielle de position ($\Delta x$) est formée qui indique la différence, établie au cours de l'intervalle d'interrogation précédent, entre les données de position incrémentales ($x_{rel}$) déterminées en dernier et les données de position absolue ($x_{abs}$) déterminées pour la première fois.

2. Procédé selon la revendication 1, selon lequel la valeur différentielle de position ($\Delta x$) est formée côté système de mesure de position et, lors de la première transmission de données de position absolue ($x_{abs}(t_n)$), la valeur différentielle de position ($\Delta x$) est transmise en outre à l'unité d'exploitation.

**3.** Procédé selon la revendication 2, selon lequel les données de position incrémentales ($x_{rel}(t_n)$) côté système de mesure de position sont déterminées via une première unité de compteur (1) et les données de position absolue ($x_{abs}(t_n)$) sont déterminées via une seconde unité de compteur (2) et, lors de la première transmission des données de position absolue ($x_{abs}(t_n)$), on transmet en outre la différence entre les deux états des compteur, au niveau de la position absolue définie, en tant que valeur différentielle de position ($\Delta x$) à l'unité d'exploitation (5).

**4.** Procédé selon la revendication 1, selon lequel des données de position incrémentales ($x_{rel}(t_n)$) sont transmises à l'unité d'exploitation (5), jusqu'à ce qu'un repère de référence (22.1) soit atteint pour la première fois sur la règle de mesure (20) du système de mesure de position, dans une position absolue définie.

**5.** Procédé selon la revendication 1, selon lequel des données de position incrémentales ($x_{rel}(t_n)$) sont transmises à l'unité d'exploitation (5), jusqu'à ce que deux repères de référence (32.4, 32.5) aient été balayés sur la règle de mesure (30) du système de mesure de position, dont la distance relative ($d_{45}$) permet de déterminer la position absolue définie du second repère de référence (32.5) balayé sur la règle de mesure (30).

**6.** Procédé selon la revendication 1, selon lequel, aussi bien concernant les données de position incrémentales ($x_{rel}(t_n)$) que concernant les données de position absolue ($x_{abs}(t_n)$), on transmet chaque fois à l'unité d'exploitation (5) un signal d'identification (IS) univoque concernant le type de signal en cours de transmission.

**7.** Procédé selon la revendication 5, selon lequel le signal d'identification (IS) transmis peut avoir deux états logiques possibles, qui sont liés de manière univoque à la transmission des données de position incrémentales ($x_{rel}(t_n)$) ou des données de position absolue ($x_{abs}(t_n)$).

**8.** Procédé selon la revendication 1, selon lequel, après que la position absolue a été atteinte, aussi bien des données de position incrémentales ($x_{rel}(t_n)$) que des données de position absolue ($x_{abs}(t_n)$) sont transmises par le système de mesure de position à l'unité d'exploitation (5), et la valeur différentielle de position ($\Delta x$) est formée côté unité d'exploitation (5), à partir des données transmises ($x_{rel}(t_n)$), ($x_{abs}(t_n)$).

**9.** Procédé selon la revendication 1, selon lequel on détermine, à l'aide de la valeur différentielle de position, la vitesse relative entre les éléments mobiles l'un par rapport à l'autre, au cours d'un intervalle d'interrogation qui précède la première transmission de données de position absolue ($x_{abs}(t_n)$).

**10.** Système de mesure de position pour déterminer la position relative de deux éléments pouvant être déplacés l'un par rapport à l'autre, comprenant

- des moyens pour identifier une position absolue ($x_{abs}(t_R)$), définie connue, des deux éléments mobiles l'un par rapport à l'autre,
- des moyens pour la transmission en série de données de position incrémentales ($x_{rel}(t_n)$) et de données de position absolue ($x_{abs}(t_n)$) à une unité d'exploitation (5), une transmission en série de données de position absolue ($x_{abs}(t_n)$) ayant lieu après l'identification de la position absolue connue, et
- deux unités de compteur (1, 2), parmi lesquelles la première unité de compteur (1) fournit, côté sortie, les données de position incrémentales ($x_{rel}(t_n)$), alors que la seconde unité de compteur (2) fournit, côté sortie, les données de position absolue ($x_{abs}(t_n)$).

**11.** Système de mesure de position selon la revendication 10, dans lequel il est prévu, en aval des deux unités de compteur, une unité de traitement de signaux (3) qui garantit que lors de la première transmission de données de position absolue ($x_{abs}(t_n)$), une valeur différentielle de position ($\Delta x$) puisse être transmise à l'unité d'exploitation (5), qui indique la différence entre les données de position incrémentales déterminées en dernier et les données de position absolue déterminées pour la première fois.

**12.** Système de mesure de position selon la revendication 10, dans lequel un signal d'identification (IS) associé peut être transmis à l'unité d'exploitation (5), aussi bien avec les données de position incrémentales ($x_{rel}(t_n)$) qu'avec les données de position absolue ($x_{abs}(t_n)$).

**13.** Système de mesure de position selon la revendication 10, dans lequel, pour déterminer une position absolue, au moins un repère de référence (22.1) est disposé à une position absolue définie sur la règle de mesure (20) du système de mesure de position (10).

**14.** Système de mesure de position selon la revendication 10, dans lequel, pour déterminer une position absolue, au moins deux repères de référence (32.4, 32.5) sont disposés à une distance ($d_{45}$) réciproque, définie de manière univoque, sur la règle de mesure (20) du dispositif de mesure de position (10).

FIG. 1

FIG. 2

Position X —

60
50
40
30
20
10
0

Relativ-position $X_{rel}$

$X_{rel(t_R)}$

$\Delta X$

Absolut-position $X_{abs}$

$X_{abs(t_R)}$

$t_0$  $t_1$  $t_2$  $t_3$  $t_4$  $t_5$  $t_6$  $t_7$  $t_8$

$\Delta T_A$

$t_R$  $\Delta T_R$

Zeit —

21
22
22.1
20

IS —

1
0

$t_1$  $t_2$  $t_3$  $t_4$  $t_5$  $t_6$  $t_7$  $t_8$

Zeit —

EP 1 056 989 B1

FIG. 3

FIG. 4

FIG. 5

EP 1 056 989 B1